# EUROPEAN PATENT APPLICATION

(11) **EP 2 416 077 A1**
(43) Date of publication of application: **08.02.2012**
(21) Application number: 10758205.8
(22) Date of filing: 23.03.2010
(51) Int. Cl.: F24F 3/14, F24F 3/153, F24F 11/02

(54) **DEHUMIDIFYING SYSTEM**

(30) Priority: 02.04.2009 JP 2009090049
(71) Applicant: Daikin Industries, Ltd., Osaka-shi, Osaka 530-8323 (JP)
(72) Inventor: OKAMOTO, Yasunori, Sakai-shi Osaka 591-8511 (JP); ISHIDA, Koichi, Sakai-shi Osaka 591-8511 (JP); UCHIDA, Hideki, Osaka-shi Osaka 550-0004 (JP)
(74) Representative: HOFFMANN EITLE
(86) International application number: PCT/JP2010/002037
(87) International publication number: WO 2010/113420

(57) **Abstract**

A dehumidification system includes: an auxiliary heat exchanger (62) connected to the heating medium circuit (41) in series with the cooling heat exchanger (61), and provided downstream of a cooling heat exchanger (61) in an air passage (52); a first air heat exchanger (63) connected to a circulation circuit (60, 130), and provided upstream of the cooling heat exchanger (61) in the air passage (52); and a second air heat exchanger (64) connected to the circulation circuit (60, 130) in series with the first air heat exchanger (63), and provided downstream of the auxiliary heat exchanger (62) in the air passage (52), wherein the heating medium circuit (41) performs a first action of sending a heating medium which is cooled in a cooling section (25), and sequentially flowed through the cooling heat exchanger (61) and the auxiliary heat exchanger (62) to the cooling section (25).

## Description

### TECHNICAL FIELD

The present invention relates to a dehumidification system which cools and dehumidifies air, and supplies the dehumidified air to the inside of a room.

### BACKGROUND ART

Dehumidification systems for supplying dehumidified air to the inside of the room have been known.

For example, Patent Document 1 discloses a dehumidification system of this type. The dehumidification system includes a cooling heat exchanger in an air passage in a casing. The cooling heat exchanger is connected to a circulation circuit in which a heating medium such as water etc. circulates. The circulation circuit includes a pump for circulating the heating medium, and a cooling section for cooling the circulating heating medium.

When the dehumidification system is operated, the pump is operated to circulate water in the circulation circuit. The water is cooled in the cooling section, and then flows through the cooling heat exchanger. The air flows through the air passage while a fan is operated. Thus, in the cooling heat exchanger, the water and the air exchange heat to cool the air to a dew point temperature or lower. As a result, moisture in the air is condensed to dehumidify the air. The air cooled and dehumidified in this manner is supplied to the inside of the room.

### CITATION LIST

### PATENT DOCUMENT

[Patent Document 1] Japanese Patent Publication No. 2006-112780

### SUMMARY OF THE INVENTION

### TECHNICAL PROBLEM

In the dehumidification system of this type described above, the air needs to be cooled to the dew point temperature or lower in the cooling heat exchanger to dehumidify the air. Thus, the cooling section of the circulation circuit needs to cool the heating medium to a relatively low temperature. Therefore, relatively high cooling capacity is required in the cooling section, which reduces energy-saving effect.

In view of the foregoing, the present invention has been achieved. The invention is concerned with providing an energy-saving dehumidification system.

### SOLUTION TO THE PROBLEM

According to a first aspect of the invention, a dehumidification system includes: a casing (51) which forms an air passage (52) through which air flows; a heating medium circuit (41) which includes a cooling section (25) for cooling a predetermined heating medium, and in which the heating medium circulates; a cooling heat exchanger (61) which is connected to the heating medium circuit (41), and is provided in the air passage (52) to cool and dehumidify the air by the heating medium flowing through the cooling heat exchanger (61) to supply the dehumidified air to the inside of a room. The dehumidification system includes: an auxiliary heat exchanger (62) which is connected to the heating medium circuit (41) in series with the cooling heat exchanger (61), and is arranged downstream of the cooling heat exchanger (61) in the air passage (52); a first air heat exchanger (63) which is connected to a circulation circuit (60, 130) in which the predetermined heating medium circulates, and is arranged upstream of the cooling heat exchanger (61) in the air passage (52); and a second air heat exchanger (64) which is connected to the circulation circuit (60, 130) in series with the first air heat exchanger (63), and is arranged downstream of the auxiliary heat exchanger (62) in the air passage (52), wherein the heating medium circuit (41) performs a first action of sending the heating medium which is cooled in the cooling section (25), and sequentially flowed through the cooling heat exchanger (61) and the auxiliary heat exchanger (62) to the cooling section (25).

According to the first aspect of the invention, the auxiliary heat exchanger (62) is provided downstream of the cooling heat exchanger (61) in the air passage (52) in the casing (51), the first air heat exchanger (63) is provided upstream of the cooling heat exchanger (61), and the second air heat exchanger (64) is provided downstream of the auxiliary heat exchanger (62). The air flowing in the air passage (52) first passes through the first air heat exchanger (63). The heating medium circulating in the circulation circuit (60, 130) flows in the first air heat exchanger (63). Thus, the air and the heating medium exchange heat, and the air is cooled by the heating medium in the first air heat exchanger (63). On the other hand, the heating medium is heated by the air in the first air heat exchanger (63).

The air cooled in the first air heat exchanger (63) passes through the cooling heat exchanger (61). In the heating medium circuit (41) performing the first action, the heating medium cooled in the cooling section (25) sequentially flows through the cooling heat exchanger (61) and the auxiliary heat exchanger (62). Thus, the air is cooled to a dew point temperature or lower by the heating medium of relatively low temperature, and is dehumidified in the cooling heat exchanger (61). On the other hand, the heating medium is heated by the air in the cooling heat exchanger (61).

The air cooled in the cooling heat exchanger (61) passes through the auxiliary heat exchanger (62). The heating medium heated in the cooling heat exchanger (61) flows in the in the auxiliary heat exchanger (62). Thus, the air is heated by the heating medium of relatively high temperature in the auxiliary heat exchanger (62). Thus, relative humidity of the air is reduced. On the other hand, the heating medium is cooled by the air in the auxiliary heat exchanger (62). Thus, the temperature of the heating medium sent to the cooling section (25) of the heating medium circuit (41) is reduced, thereby reducing cooling capacity required to cool the heating medium in the cooling section (25).

The air heated in the auxiliary heat exchanger (62) passes through the second air heat exchanger (64). The heating medium heated in the first air heat exchanger (63) flows in the second air heat exchanger (64). Thus, the air is further heated by the heating medium of relatively high temperature in the second air heat exchanger (64). This further reduces the relative humidity of the air.

According to a second aspect related to the first aspect of the invention, the dehumidification system further includes: a heating section (55) which is arranged downstream of the second air heat exchanger (64) in the air passage (52) to heat the air.

According to the second aspect of the invention, the heating section (55) is provided downstream of the second air heat exchanger (64). Thus, the air which passed through the second air heat exchanger (64) can be heated by the heating section (55). This can further reduce the relative humidity of the air which passed through the heating section (55). The air before flowing into the heating section (55) has already been heated by the auxiliary heat exchanger (62) and the second air heat exchanger (64) as described above. Therefore, heating capacity required to heat the air in the heating section (55) can be reduced.

According to a third aspect related to the first or second aspect of the invention, the cooling heat exchanger (61) includes an inlet (71a) which is positioned in a downstream part of the air passage (52), and through which the heating medium flows into the cooling heat exchanger (61), an outlet (71b) which is positioned in an upstream part of the air passage (52), and through which the heating medium flows out of the cooling heat exchanger (61), and an intermediate passage (61 c) formed between the inlet (71 a) and the outlet (71b).

In the cooling heat exchanger (61) according to the third aspect of the invention, the inlet (71a) through which the heating medium flows into the cooling heat exchanger (61) is provided in the downstream part of the air passage (52), the outlet (71b) through which the heating medium flows out of the cooling heat exchanger (61) is provided in the upstream part of the air passage (52), and the intermediate passage (61c) through which the heating medium flows is formed between the inlet (71a) and the outlet (71b). Thus, in the cooling heat exchanger (61) during the first action, the air and the heating medium flow substantially in opposite directions to exchange heat therebetween. Specifically, in the present invention, the cooling heat exchanger (61) during the first action can function as a so-called convection heat exchanger. With this configuration, the temperature of the air flowing out of the cooling heat exchanger (61) approaches the temperature of the heating medium flowing through the inlet (71a). Thus, for example, as compared with a so-called parallel heat exchanger, the cooling heat exchanger (61) can cool/dehumidify the air more effectively. On the other hand, the temperature of the heating medium flowing through the outlet (71b) of the cooling heat exchanger (61) approaches the temperature of the air flowing into the cooling heat exchanger (61). Thus, for example, as compared with the parallel heat exchanger, the cooling heat exchanger (61) can increase the temperature of the heating medium sent from the cooling heat exchanger (61) to the auxiliary heat exchanger (62).

With this configuration, the heating medium which is cooled to a relatively low temperature in the cooling heat exchanger (61) and the air which is heated to a relatively high temperature in the cooling heat exchanger (61) exchange heat in the auxiliary heat exchanger (62). Thus, a difference in temperature between the heating medium and the air in the auxiliary heat exchanger (62) increases, thereby effectively cooling the heating medium by the air (i.e., effectively heating the air by the heating medium). This can further reduce the relative humidity of the air, thereby improving the dehumidification of the air. Since the temperature of the heating medium sent to the cooling section (25) of the heating medium circuit (41) can further be reduced, the cooling capacity required to cool the heating medium in the cooling section (25) can further be reduced.

According to a fourth aspect of the invention related to any one of the first to third aspects of the invention, the auxiliary heat exchanger (62) includes an inlet (72a) which is positioned in the downstream part of the air passage (52), and through which the heating medium flows into the auxiliary heat exchanger (62), an outlet (72b) which is positioned in the upstream part of the air passage (52), and through which the heating medium flows out of the auxiliary heat exchanger (62), and an intermediate passage (62c) formed between the inlet (72a) and the outlet (72b).

In the auxiliary heat exchanger (62) according to the fourth aspect of the invention, the inlet (72a) through which the heating medium flows into the auxiliary heat exchanger (62) is provided in the downstream part of the air passage (52), the outlet (72b) through which the heating medium flows out of the auxiliary heat exchanger (62) is provided in the upstream part of the air passage (52), and the intermediate passage (62c) through which the heating medium flows is formed between the inlet (72a) and the outlet (72b). Thus, in the auxiliary heat exchanger (62) during the first action, the air and the heating medium flow substantially in the opposite directions to exchange heat therebetween. With this configuration, the temperature of the air flowing out of the auxiliary heat exchanger (62) approaches the temperature of the heating medium flowing through the inlet (72a). Thus, for example, as compared with the so-called parallel heat exchanger, the auxiliary heat exchanger (62) can heat the air more effectively. The temperature of the heating medium flowing through the outlet (72b) of the auxiliary heat exchanger (62) approaches the temperature of the air flowing into the auxiliary heat exchanger (62). Thus, for example, as compared with the parallel heat exchanger, the temperature of the heating medium sent to the cooling section (25) of the heating medium circuit (41) can further be reduced. This can further reduce the cooling capacity required to cool the heating medium in the cooling section (25).

According to a fifth aspect of the invention related to any one of the first to fourth aspects of the invention, the first air heat exchanger (63) includes an inlet (73a) which is positioned in the downstream part of the air passage (52), and through which the heating medium flows into the first air heat exchanger (63), an outlet (73b) which is positioned in the upstream part of the air passage (52), and through which the heating medium flows out of the first air heat exchanger (63), and an intermediate passage (63c) formed between the inlet (73a) and the outlet (73b).

In the first air heat exchanger (63) according to the fifth aspect of the invention, the inlet (73a) through which the heaving medium flows into the first air heat exchanger (63) is provided in the downstream part of the air passage (52), the outlet (73b) through which the heating medium flows out of the first air heat exchanger (63) is provided in the upstream part of the air passage (52), and the intermediate passage (63c, 63c, ...) through which the heating medium flows is formed between the inlet (73a) and the outlet (73b). Thus, in the first air heat exchanger (63), the air and the heating medium flow substantially in the opposite directions to exchange heat therebetween. In the present invention, the first air heat exchanger (63) can function as the so-called convection heat exchanger. With this configuration, the temperature of the air flowing out of the first air heat exchanger (63) approaches the temperature of the heating medium flowing through the inlet (73a). Thus, for example, as compared with the parallel heat exchanger, the first air heat exchanger (63) can cool the air more effectively.

On the other hand, the temperature of the heating medium flowing through the outlet (73b) of the first air heat exchanger (63) approaches the temperature of the air flowing into the first air heat exchanger (63). Thus, for example, as compared with the parallel heat exchanger, the first air heat exchanger (63) can increase the temperature of the heating medium sent from the first air heat exchanger (63) to the second air heat exchanger (64). Thus, a difference in temperature between the air and the heating medium in the second air heat exchanger (64) increases, thereby improving the heating of the air in the second air heat exchanger (64). This can further reduce the relative humidity of the air in the second air heat exchanger (64).

According to a sixth aspect of the invention related to any one of the first to fifth aspects of the invention, the second air heat exchanger (64) includes an inlet (74a) which is positioned in the downstream part of the air passage (52), and through which the heating medium flows into the second air heat exchanger (64), an outlet (74b) which is positioned in the upstream part of the air passage (52), and through which the heating medium flows out of the second air heat exchanger (64), and an intermediate passage (64c) formed between the inlet (74a) and the outlet (74b).

In the second air heat exchanger (64) according to the sixth aspect of the invention, the inlet (74a) through which the heating medium flows into the second air heat exchanger (64) is provided in the downstream part of the air passage (52), the outlet (74b) through which the heating medium flows out of the second air heat exchanger (64) is provided in the upstream part of the air passage (52), and the intermediate passage (64c) through which the heating medium flows is formed between the inlet (74a) and the outlet (74b). Thus, in the second air heat exchanger (64), the air and the heating medium can flow substantially in the opposite directions to exchange heat therebetween. Specifically, in the present invention, the second air heat exchanger (64) can function as the so-called convection heat exchanger. With this configuration, the temperature of the air flowing out of the second air heat exchanger (64) approaches the temperature of the heating medium flowing through the inlet (74a). Thus, for example, as compared with the parallel heat exchanger, the first air heat exchanger (63) can heat the air more effectively. This can further reduce the relative humidity of the air in the second air heat exchanger (64).

On the other hand, the temperature of the heating medium flowing through the outlet (74b) of the second air heat exchanger (64) approaches the temperature of the air flowing into the second air heat exchanger (64). Thus, for example, as compared with the parallel heat exchanger, the second air heat exchanger (64) can cool the heating medium more effectively. Thus, the temperature of the heating medium sent from the second air heat exchanger (64) to the first air heat exchanger (63) can further be reduced, thereby cooling the air more effectively in the first air heat exchanger (63).

According to a seventh aspect of the invention related to any one of the first to sixth aspects of the invention, the heating medium circuit (41) is configured to perform the first action, and a second action of sending the heating medium which is cooled in the cooling section (25), and sequentially flowed through the auxiliary heat exchanger (62) and the cooling heat exchanger (61) to the cooling section (25) in a switchable manner.

In the heating medium circuit (41) according to the seventh aspect of the invention, the second action is performed in addition to the above-described first action. In the heating medium circuit (41) performing the second action, the heating medium cooled in the cooling section (25) sequentially flows through the auxiliary heat exchanger (62) and the cooling heat exchanger (61). Specifically, in the air passage (52), the air sequentially flows through the cooling heat exchanger (61) and the auxiliary heat exchanger (62), while the heating medium flows in the opposite way. Thus, different from the first action, the heating medium cooled in the cooling section (25) first flows through the auxiliary heat exchanger (62), and the air is cooled by the heating medium. As a result, the air is cooled in both of the cooling heat exchanger (61) and the auxiliary heat exchanger (62) in the second action, thereby improving the dehumidification of the air.

According to an eighth aspect of the invention related to any one of the first to seventh aspects of the invention, the dehumidification system further includes: a branch passage (66) which diverts the heating medium circulating in the circulation circuit (60, 130), and introduces the diverted heating medium into the circulation circuit (60, 130); an auxiliary cooling section (95) which cools the heating medium flowing through the branch passage (66); and a diverted flow control mechanism (97) which regulates a flow rate of the heating medium flowing through the branch passage (66).

In the eighth aspect of the invention, the diverted flow control mechanism (97) regulates the flow rate of the heating medium flowing through the branch passage (66), thereby changing the cooling capacity required to cool the air in the first air heat exchanger (63). Specifically, for example, when the diverted flow control mechanism (97) increases the flow rate of the heating medium flowing through the branch passage (66), an amount of the heating medium cooled in the an auxiliary cooling unit (95) is increased. Thus, the temperature of the heating medium returned to the circulation circuit (60, 130) is reduced, and the cooling capacity of the first air heat exchanger (63) is reduced.

For example, when the diverted flow control mechanism (97) reduces the flow rate of the heating medium flowing through the branch passage (66), the amount of the heating medium cooled in the an auxiliary cooling unit (95) is reduced. Thus, the temperature of the heating medium returned to the circulation circuit (60, 130) is increased, and the cooling capacity of the first air heat exchanger (63) is increased.

According to a ninth aspect of the invention related to any one of the first to eighth aspects of the invention, the dehumidification system further includes: a flow rate control mechanism (35-37, 65) which separately regulates a flow rate of the heating medium flowing through the first air heat exchanger (63), and a flow rate of the heating medium flowing through the second air heat exchanger (64).

In the ninth aspect of the invention, the flow rate control mechanism (35-37, 65) can separately regulate the flow rates of the heating medium flowing through the first air heat exchanger (63) and the second air heat exchanger (64). Thus, for example, cooling/dehumidifying capacity required to cool/dehumidify the air in the first air heat exchanger (63) can be changed by changing the flow rate of the heating medium flowing through the first air heat exchanger (63). Further, air heating capacity required to heat the air in the second air heat exchanger (64) can be changed by changing the flow rate of the heating medium flowing through the second air heat exchanger (64).

According to a tenth aspect of the invention related to any one of the first to ninth aspects of the invention, the dehumidification system further includes: an exhaust passage (59) through which the air in the room is discharged outside; and a sensible heat exchanger (68) in which the heating medium flowing through the circulation circuit (60, 130) and the air flowing through the exhaust passage (59) exchange heat.

In the tenth aspect of the invention, the room air is discharged outside through the exhaust passage (59). In this case, the heating medium used to cool the air in the first air heat exchanger (63) exchanges heat with the room air in the sensible heat exchanger (68) provided in the exhaust passage (59). Thus, for example, when the temperature of the room air flowing through the exhaust passage (59) is relatively low, cold of the room air can be added to the heating medium. This can improve the cooling of the air in the first air heat exchanger(63).

For example, when the temperature of the room air flowing through the exhaust passage (59) is relatively high, the heat of the room air can be added to the heating medium. This can improve the heating of the air in the second air heat exchanger (64).

According to an eleventh aspect of the invention related to any one of the first to tenth aspects of the invention, the dehumidification system further includes: a bypass passage (140) which transfers the air in the air passage (52) upstream of the first air heat exchanger (63) to the downstream of the cooling heat exchanger (61); and a bypass flow control mechanism (141) which regulates a flow rate of the air flowing through the bypass passage (140).

In the eleventh aspect of the invention, the bypass passage (140) is provided in the air passage (52), and the flow rate of the air flowing through the bypass passage (140) can be regulated by the bypass flow control mechanism (141). For example, when the flow rate of the air flowing through the bypass passage (140) is increased, the flow rate of the air which is cooled/dehumidified in the first air heat exchanger (63) and the cooling heat exchanger (61) is reduced. Thus, an amount of latent heat handled by the dehumidification system is reduced. For example, when the flow rate of the air flowing through the bypass passage (140) is reduced, the flow rate of the air which is cooled/dehumidified in the first air heat exchanger (63) and the cooling heat exchanger (61) is increased. Thus, in the present invention, changing the flow rate of the air flowing through the bypass passage (140) allows operation corresponding to a latent heat load.

### ADVANTAGES OF THE INVENTION

In the present invention, the air is cooled in advance by the heating medium flowing through the first air heat exchanger (63), and then the air is cooled/dehumidified in the cooling heat exchanger (61). This can reduce the cooling capacity required to cool the air in the cooling heat exchanger (61), and can reduce the cooling capacity required to cool the air in the cooling section (25) of the heating medium circuit (41). In the auxiliary heat exchanger (62), the air is heated by heat collected from the air in the cooling heat exchanger (61). This can improve the dehumidifying capacity, and the temperature of the heating medium sent to the cooling section (25) can be reduced. Thus, the cooling capacity required in the cooling section (25), and an amount of the heating medium circulating in the heating medium circuit (41) can be both reduced. In the second air heat exchanger (64), the air is heated by heat collected from the air in the first air heat exchanger (63). This can further improve the dehumidifying capacity, and cold collected from the air can be used again to cool the air in the first air heat exchanger (63). Thus, the present invention can improve the dehumidifying capacity, while significantly reducing energy consumption of the dehumidification system.

In the second aspect of the invention, the air can be heated in the auxiliary heat exchanger (62) and the second air heat exchanger (64), thereby reducing the heating capacity required to heat the air in the heating section (55). This can further reduce the energy consumption of the dehumidification system.

In the third aspect of the invention, the air and the heating medium flow in the opposite directions in the cooling heat exchanger (61) to exchange heat therebetween. Thus, in the cooling heat exchanger (61) during the first action, the air can be cooled to a lower temperature, and the heating medium can be heated to a higher temperature. This can reduce the cooling capacity required in the cooling section (25), and the heating capacity required in the heating section (55) etc., thereby further reducing energy consumption of the dehumidification system. In the fourth aspect of the invention, the heating medium and the air flow in the opposite directions in the auxiliary heat exchanger (62) during the first action to exchange heat therebetween. Thus, the temperature of the heating medium flowing out of the auxiliary heat exchanger (62) is further reduced, and the temperature of the air passing through the auxiliary heat exchanger (62) is further increased. This can further reduce the cooling capacity required in the cooling section (25), and the heating capacity required in the heating section (55) etc.

In the fifth aspect of the invention, the air and the heating medium flow in the opposite directions in the first air heat exchanger (63) to exchange heat therebetween. Thus, the air can be cooled to a lower temperature, and the heating medium can be heated to a higher temperature in the first air heat exchanger (63). This can further reduce the cooling capacity required in the cooling heat exchanger (61), and the heating capacity required in the heating section (55), and can further reduce the energy consumption of the dehumidification system.

In the sixth aspect of the invention, the air and the heating medium flow in the opposite directions in the second air heat exchanger (64) to exchange heat therebetween. Thus, the air can be heated more effectively in the second air heat exchanger (64), and an amount of the cold collected from the air in the second air heat exchanger (64) is increased. Therefore, the air is cooled more effectively in the first air heat exchanger (63).

In the seventh aspect of the invention, the second action of feeding the air to sequentially flow through the cooling heat exchanger (61) and the auxiliary heat exchanger (62), and simultaneously feeding the heating medium to sequentially flow through the auxiliary heat exchanger (62) and the cooling heat exchanger (61) is performed. Thus, different from the first action, the air can be cooled in both of the cooling heat exchanger (61) and the auxiliary heat exchanger (62). Therefore, the air can be dehumidified more effectively in the second action than in the first action. Even when the temperature and humidity of the target air are high, the air can reliably be dehumidified by performing the second action.

In the eighth aspect of the invention, the flow rate of the heating medium sent to the branch passage (66) is regulated to suitably regulate the cooling capacity required in the first air heat exchanger (63). Thus, the dehumidification system can be operated in accordance with the humidity and temperature of the target air. Since the auxiliary cooling unit (95) reduces the temperature of the heating medium, the air can be cooled/dehumidified also in the second air heat exchanger (64).

In the ninth aspect of the invention, the flow rate of the heating medium flowing through the first air heat exchanger (63), and the flow rate of the heating medium flowing through the second air heat exchanger (64) can separately be regulated. Thus, the cooling capacity required to cool the air in the first air heat exchanger (63), and the heating capacity required to heat the air in the second air heat exchanger (64) can separately be changed. Therefore, the operation can be optimized in accordance with operating conditions.

In the tenth aspect of the invention, the air discharged from the inside of the room and the heating medium flowing through the heating medium circuit (41) exchange heat in the sensible heat exchanger (68). When the room is cooled, the cold of the air is added to the heating medium flowing through the heating medium circuit (41), thereby cooling the air more effectively in the first air heat exchanger (63). For example, when the room is heated, the heat of the air is added to the heating medium flowing through the heating medium circuit (41), thereby heating the air more effectively in the second air heat exchanger (64).

In the eleventh aspect of the invention, the flow rate of the air flowing through the bypass passage (140) is regulated to regulate the flow rate of the air flowing through the first air heat exchanger (63) and the cooling heat exchanger (61). Thus, the dehumidifying capacity required to dehumidify the air, and the cooling capacity required to cool the air in the dehumidification system can separately be regulated. This allows cooling/dehumidifying operation optimized in accordance with the operating conditions and needs associated with the operation.

### BRIEF DESCRIPTION OF THE DRAWINGS

[FIG. 1] FIG. 1 is a schematic view illustrating a general structure of a dehumidification system according to a first embodiment.
[FIG. 2] FIG. 2 is a schematic view illustrating heat exchangers in an air conditioning unit.
[FIG. 3] FIG. 3 is a schematic view illustrating the heat exchangers in the air conditioning unit together with a flow of a heating medium during heat recovery operation.
[FIG. 4] FIG. 4 is a schematic view illustrating the heat exchangers in the air conditioning unit together with a flow of the heating medium during dehumidification-dominant operation.
[FIG. 5] FIG. 5 is a schematic view illustrating a general structure of a dehumidification system according to a first alternative.
[FIG. 6] FIG. 6 is a schematic view illustrating heat exchangers in an air conditioning unit according to the first alternative together with a flow of a heating medium when a three-way valve is set to a first state.
[FIG. 7] FIG. 7 is a schematic view illustrating the heat exchangers in the air conditioning unit according to the first alternative together with a flow of the heating medium when the three-way valve is set to a second state.
[FIG. 8] FIG. 8 is a schematic view illustrating a general structure of a dehumidification system according to a second alternative.
[FIG. 9] FIG. 9 is a schematic view illustrating a general structure of a dehumidification system according to a third alternative.
[FIG. 10] FIG. 10 is a schematic view illustrating a general structure of a dehumidification system according to a fourth alternative.
[FIG. 11] FIG. 11 is a schematic view illustrating a general structure of a dehumidification system according to a fifth alternative.
[FIG. 12] FIG. 12 is a schematic view illustrating a general structure of a dehumidification system according to a sixth alternative.
[FIG. 13] FIG. 13 is a schematic view illustrating a general structure of a dehumidification system according to a seventh alternative.
[FIG. 14] FIG. 14 is a schematic view illustrating a general structure of an air conditioning unit of another dehumidification system according to the seventh alternative.

### DESCRIPTION OF EMBODIMENTS

Embodiments of the present invention will be described in detail below with reference to the drawings.

### [First Embodiment]

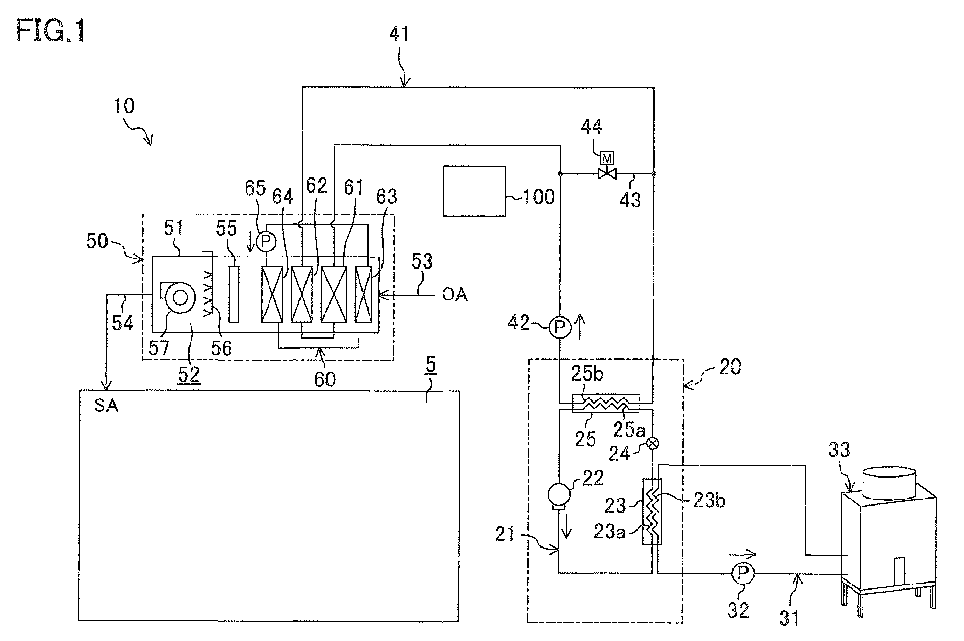

A dehumidification system according to a first embodiment regulates room humidity and room temperature, and constitutes, for example, an air conditioning system (10) applied to semiconductor factories etc. As shown in FIG. 1, the air conditioning system (10) according to the first embodiment is configured to take outside air (OA), conditions humidity and temperature of the air, and supplies the conditioned air as supply air (SA) to the inside of a room. The air conditioning system (10) includes a chiller unit (20), and an air conditioning unit (50). The air conditioning system (10) further includes a refrigerant circuit (21), a radiation circuit (31), and a heating medium circuit (41).

### <Structure of Refrigerant Circuit>

The refrigerant circuit (21) is included in the chiller unit (20). The refrigerant circuit (21) constitutes a closed circuit filled with a refrigerant. A compressor (22), a radiator (23), an expansion valve (24), and an evaporator (25) are connected to the refrigerant circuit (21). The refrigerant circuit (21) performs a vapor compression refrigeration cycle by circulating the refrigerant.

The radiator (23) includes a first heat transfer pipe (23a) connected to the refrigerant circuit (21), and a second heat transfer pipe (23b) connected to the radiation circuit (31). Thus, the refrigerant circuit (21) is connected to the radiation circuit (31) through the radiator (23). In the radiator (23), the refrigerant flowing through the first heat transfer pipe (23a) and a heating medium flowing through the second heat transfer pipe (23b) exchange heat. The evaporator (25) includes a first heat transfer pipe (25a) connected to the refrigerant circuit (21), and a second heat transfer pipe (25b) connected to the heating medium circuit (41). Thus, the refrigerant circuit (21) is connected to the heating medium circuit (41) through the evaporator (25). In the evaporator (25), the refrigerant slowing through the first heat transfer pipe (25a) and the heating medium flowing through the second heat transfer pipe (25b) exchange heat.

### <Structure of Radiation circuit>

The radiation circuit (31) constitutes a closed circuit filled with water as the heating medium. The radiator (23), a water pump (32), and a cooling tower (33) are connected to the radiation circuit (31). The water pump (32) transfers and circulates the water in the radiation circuit (31). The cooling tower (33) constitutes a cooling member for cooling the water circulating in the radiation circuit (31). An arrow shown near the water pump (32) in the drawings indicates a direction of the water circulated in the radiation circuit (31).

### <Structure of Circulation Circuit>

The heating medium circuit (41) constitutes a closed circuit filled with water as the heating medium. The evaporator (25), a chiller pump (42), and a cooling heat exchanger (61) are connected to the heating medium circuit (41). The evaporator (25) constitutes a heating medium cooling section for cooling the heating medium circulating in the heating medium circuit (41). The chiller pump (42) constitutes a heating medium transfer mechanism for transferring and circulating the water in the heating medium circuit (41). Details of the cooling heat exchanger (61) will be described later. An arrow shown near the chiller pump (42) in the drawings indicates a direction of the water flowing in the heating medium circuit (41).

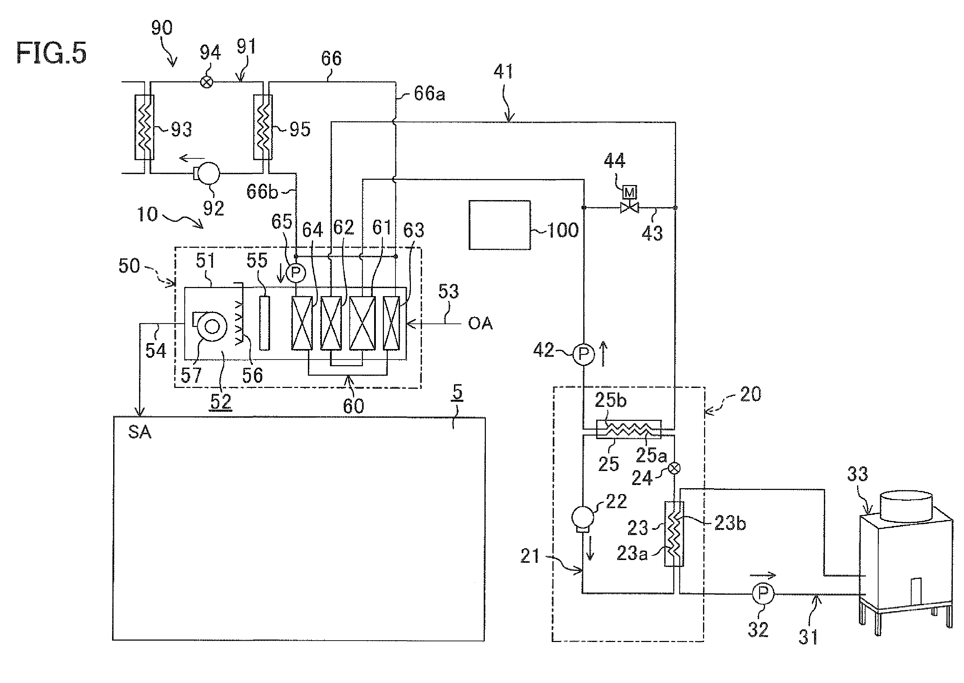

A water bypass pipe (43) is connected to the heating medium circuit (41). An end of the water bypass pipe (43) is connected between the chiller pump (42) and the cooling heat exchanger (61). The other end of the water bypass pipe (43) is connected between the cooling heat exchanger (61) and the evaporator (25). A motor-operated bypass valve (44) is provided in the water bypass pipe (43). The motor-operated bypass valve (44) constitutes a flow rate control valve which can regulate the degree of opening of the water bypass pipe (43). In FIG. 1 (and FIGS. 5, and 8-14), pipes are partially emitted to schematically show how the pipes are communicated with each other during a first action described in detail later.

### <Structure of Air Conditioning Unit>

The air conditioning unit (50) includes a casing (51) which is in the shape of a horizontally oriented flat rectangular parallelepiped. An air passage (52) through which air flows is formed in the casing (51). An inlet end of the air passage (52) is connected to an end of an inlet duct (53). The other end of the inlet duct (53) is opened outside the room. An outlet end of the air passage (52) is connected to an end of a supply duct (54). The other end of the supply duct (54) is opened in a room (5).

The air passage (52) includes a first air heat exchanger (63), the cooling heat exchanger (61), an auxiliary heat exchanger (62), a second air heat exchanger (64), an electric heater (55), a sprinkler (56), and a blower (57) sequentially arranged from upstream to downstream in the air passage. The electric heater (55) is provided downstream of the second air heat exchanger (64) to constitute an air heating section for heating the air. The sprinkler (56) constitutes a humidifying section which sprinkles water in a tank (not shown) in the air through a nozzle. The blower (57) constitutes an air transfer mechanism which transfers the air in the air passage (52).

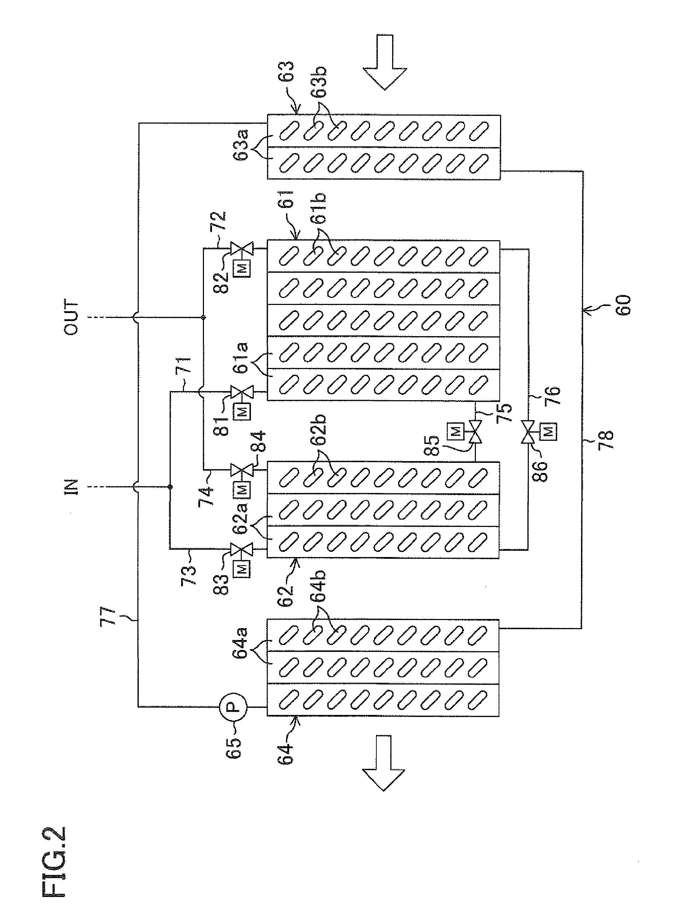

The cooling heat exchanger (61) described above constitutes an air cooling section for cooling the air to a dew point temperature or lower. As shown in FIGS. 2-4, the cooling heat exchanger (61) includes a plurality of fins (61a), and a heat transfer tube (61b) penetrating the fins (61a) to constitute a so-called fin-and-tube heat exchanger. The cooling heat exchanger (61) includes fin sets each containing five fins arranged in a direction of air flow.

The cooling heat exchanger (61) includes an inlet (71a) which is positioned in a downstream part of the air passage (52), and through which water flows into the cooling heat exchanger (61), and an outlet (71b) which is positioned in an upstream part of the air passage (52), and through which water flows out of the cooling heat exchanger (61). A first inlet pipe (71) and a first outlet pipe (72) are connected to the inlet (71a) and the outlet (71b) of the cooling heat exchanger (61), respectively.

Each of the inlet (71a) and the outlet (71b) of the cooling heat exchanger (61) is divided into two or more branches by a flow divider. The branches of the inlet (71a) are connected to inlet ends of a plurality of paths (61c, 61c, ...) in the cooling heat exchanger (61), and the branches of the outlet (71b) are connected to outlet ends of a plurality of paths (61c, 61c, ...) in the cooling heat exchanger (61). The paths (61c, 61c, ...) are aligned in the vertical direction to be parallel with each other, and extend between the inlet (71 a) and the outlet (71b). The paths (61 c, 61c, ...) constitute an intermediate passage formed between the inlet (71a) and the outlet (71b).

The auxiliary heat exchanger (62) is provided downstream of the cooling heat exchanger (61). The auxiliary heat exchanger (62) includes a plurality of fins (62a), and a heat transfer tube (62b) penetrating the fins (62a) to constitute the so-called fin-and-tube heat exchanger. The auxiliary heat exchanger (62) includes fin sets each containing three fins arranged in the direction of air flow. Specifically, the number of the fins in each fin set of the auxiliary heat exchanger (62) is smaller than the number of the fins in each fin set of the cooling heat exchanger (61).

The auxiliary heat exchanger (62) includes an inlet (72a) which is positioned in the downstream part of the air passage (52), and through which water flows into the auxiliary heat exchanger (62), and an outlet (72b) which is positioned in the upstream part of the air passage (52), and through which water flows out of the auxiliary heat exchanger (62). A second inlet pipe (73) and a second outlet pipe (74) are connected to the inlet (72a) and the outlet (72b) of the auxiliary heat exchanger (62), respectively.

Like in the cooling heat exchanger (61) described above, the inlet (72a) and the outlet (72b) of the auxiliary heat exchanger (62) are branched, and a plurality of paths (62c, 62c, ...) are formed as an intermediate passage between the inlet (72a) and the outlet (72b).

The cooling heat exchanger (61) and the auxiliary heat exchanger (62) are coupled through a first coupling pipe (75) and a second coupling pipe (76). The inlet (71a) of the cooling heat exchanger (61) and the outlet (72b) of the auxiliary heat exchanger (62) communicate with each other through the first coupling pipe (75). The outlet (71b) of the cooling heat exchanger (61) and the inlet (72a) of the auxiliary heat exchanger (62) communicate with each other through the second coupling pipe (76).

The first inlet pipe (71) has a first valve (81), the first outlet pipe (72) has a second valve (82), the second inlet pipe (73) has a third valve (83), the second outlet pipe (74) has a fourth valve (84), the first coupling pipe (75) has a fifth valve (85), and the second coupling pipe (76) has a sixth valve (86). The valves (81-86) are configured to open or close the corresponding passages. Each of the valves (81-86) of the present embodiment constitutes a flow rate control valve which can regulate the degree of opening of the corresponding passage.

The air conditioning system (10) includes a circulation circuit (60) in which water as the heating medium circulates. The first air heat exchanger (63) and the second air heat exchanger (64) are connected in series to the circulation circuit (60).

The first air heat exchanger (63) is provided upstream of the cooling heat exchanger (61) in the air passage (52). The first air heat exchanger (63) includes a plurality of fins (63a), and a heat transfer tube (63b) penetrating the fins (63a) to constitute the so-called fin-and-tube heat exchanger. The first air heat exchanger (63) includes fin sets each containing two fins arranged in the direction of the air flow.

The first air heat exchanger (63) includes an inlet (73a) which is positioned in the downstream part of the air passage (52), and through which water flows into the first air heat exchanger (63), and an outlet (73b) which is positioned in the upstream part of the air passage (52), and through which water flows out of the first air heat exchanger (63). An end of a third coupling pipe (77), and an end of a fourth coupling pipe (78) are connected to the outlet (73b) and the inlet (73a) of the first air heat exchanger (63), respectively.

Like in the cooling heat exchanger (61) described above, the inlet (73a) and the outlet (73b) of the first air heat exchanger (63) are branched, and a plurality of paths (63c, 63c, ...) are formed as an intermediate passage between the inlet (73a) and the outlet (73b).

The second air heat exchanger (64) is provided downstream of the auxiliary heat exchanger (62) in the air passage (52). The second air heat exchanger (64) includes a plurality of fins (64a), and a heat transfer tube (64b) penetrating the fins (64a) to constitute the so-called fin-and-tube heat exchanger. The second air heat exchanger (64) includes fin sets each containing three fins arranged in the direction of the air flow.

The second air heat exchanger (64) includes an inlet (74a) which is positioned in the downstream part of the air passage (52), and through which water flows into the second air heat exchanger (64), and an outlet (74b) which is positioned in the upstream part of the air passage (52), and through which water flows out of the second air heat exchanger (64). The other end of the third coupling pipe (77) and the other end of the fourth coupling pipe (78) are connected to the inlet (74a) and the outlet (74b) of the second air heat exchanger (64), respectively.

Like in the cooling heat exchanger (61) described above, the inlet (74a) and the outlet (74b) of the second air heat exchanger (64) are branched, and a plurality of paths (64c, 64c, ...) are formed as an intermediate passage between the inlet (74a) and the outlet (74b).

As described above, the first air heat exchanger (63), the third coupling pipe (77), the second air heat exchanger (64), and the fourth coupling pipe (78) are sequentially connected to constitute the closed circulation circuit (60). The third coupling pipe (77) includes a circulating pump (65) for transferring water in the circulation circuit (60).

### <Structure of Controllers

The air conditioning system (10) includes a controller (100) as a control section. A signal related to an operating state of the air conditioning system (10) is input to the controller (100). Based on the input signal, the controller (100) controls cooling capacity of the chiller unit (20), an amount of water circulating in the water pump (32), the chiller pump (42), and the circulating pump (65), heating capacity of the electric heater (55), an amount of water sprinkled by the sprinkler (56), the degree of opening of the motor-operated bypass valve (44), etc. The controller (100) controls the degree of opening of the first to six valves (81-86) in response to switching between "heat recovery operation" and "dehumidification-dominant operation" described in detail later.

### -Working Mechanism-

### [Heat Recovery Operation]

Heat recovery operation is dehumidifying operation which places importance on energy conservation than dehumidifying capacity. The heat recovery operation is carried out, for example, when temperature and humidity in the room are relatively low, i.e., in winter etc. A dehumidification load in the room (e.g., a difference between target room humidity and current room humidity) may be detected to automatically perform the heat recovery operation when the dehumidification load is relatively low.

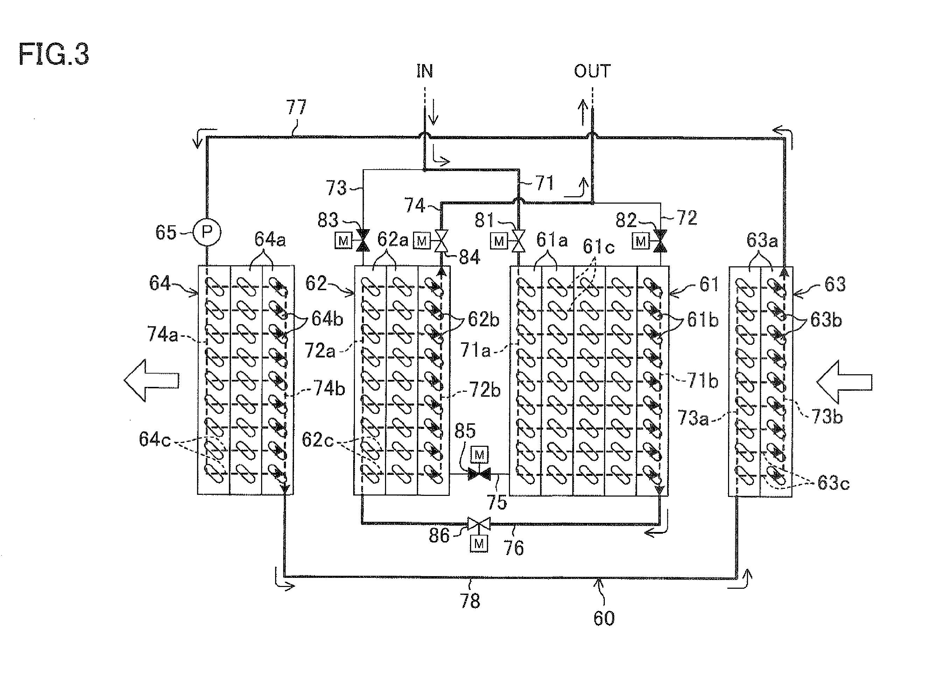

In the heat recovery operation, the compressor (22), the water pump (32), the chiller pump (42), and the blower (57) of the chiller unit (20) are driven. Basically, the electric heater (55) is turned on, and the sprinkling of the sprinkler (56) is stopped during the heat recovery operation. The controller (100) opens the first valve (81), the fourth valve (84), and the sixth valve (86), and closes the second valve (82), the third valve (83), and the fifth valve (85) (see FIG. 3).

In the heat recovery operation, the refrigerant circuit (21) performs a refrigeration cycle. Specifically, the refrigerant compressed in the compressor (22) flows through the radiator (23). In the radiator (23), the refrigerant flowing through the first heat transfer pipe (23a) dissipates heat to water flowing through the second heat transfer pipe (23b), and is condensed. The water heated by the second heat transfer pipe (23b) of the radiator (23) dissipates heat to the outside air in the cooling tower (33). The refrigerant condensed in the radiator (23) is decompressed by the expansion valve (24) as a pressure reducing mechanism, and then flows through the evaporator (25). In the evaporator (25), the refrigerant flowing through the first heat transfer pipe (25a) absorbs heat from water flowing through the second heat transfer pipe (25b), and is evaporated. The refrigerant evaporated in the evaporator (25) is sucked into the compressor (22), and is compressed.

The water cooled in the second heat transfer pipe (25b) of the evaporator (25) passes through the chiller pump (42), and is transferred to the casing (51) of the air conditioning unit (50). In the heat recovery operation, water passing through the inlet of the heating medium circuit (41) flows through the first inlet pipe (71) to enter the cooling heat exchanger (61). The water is diverted into the plurality of paths (61c, 61c, ...), and flows through the paths (61 c, 61c, ...) to the upstream of the air flow. The water that passed through the paths (61c, 61c, ...) of the cooling heat exchanger (61) flows into the auxiliary heat exchanger (62) through the second coupling pipe (76). The water is diverted into the plurality of paths (62c, 62c, ...), and flows through the paths (62c, 62c, ...) to the upstream of the air flow. The water that passed through the paths (62c, 62c,...) of the auxiliary heat exchanger (62) is returned to the evaporator (25) of the heating medium circuit (41) through the second outlet pipe (74), and is cooled in the evaporator (25).

In the heat recovery operation described above, a first action of sending the water which is cooled in the evaporator (25) of the heating medium circuit (41), and sequentially flowed through the cooling heat exchanger (61) and the auxiliary heat exchanger (62) to the evaporator (25) is performed.

In the circulation circuit (60), water transferred by the circulating pump (65) flows into the second air heat exchanger (64) through the third coupling valve (77). The water is diverted into the plurality of paths (64c, 64c, ...), and flows through the paths (64c, 64c, ...) to the upstream of the air flow. The water that passed through the paths (64c, 64c, ...) of the second air heat exchanger (64) is sent to the fourth coupling valve (78), and flows into the first air heat exchanger (63). The water is diverted into the plurality of paths (63c, 63c, ...), and flows through the paths (63c, 63c, ...) to the upstream of the air flow. The water that passed through the paths (63c, 63c, ...) of the first air heat exchanger (63) is sent to the third coupling valve (77).

In the air conditioning unit (50), the outside air (OA) taken into the inlet duct (53) from the outside of the room flows through the air passage (52) in the casing (51). The air first passes through the first air heat exchanger (63). In the first air heat exchanger (63), the water and the air flowing in substantially opposite directions exchange heat therebetween. Specifically, in the first air heat exchanger (63), for example, the air of about 30°C and the water of about 17°C exchange heat, thereby cooling the air of 30°C to about 25°C. The water flowing out of the first air heat exchanger (63) is heated to, e.g., about 20°C.

The air cooled in the first air heat exchanger (63) passes through the cooling heat exchanger (61). In the cooling heat exchanger (61), the water and the air flowing in substantially opposite directions exchange heat therebetween. As a result, the air is cooled to a dew point temperature or lower (e.g., about 10°C), and is dehumidified. The water flowing out of the cooling heat exchanger (61) is heated to, e.g., about 15°C.

The air cooled/dehumidified in the cooling heat exchanger (61) passes through the auxiliary heat exchanger (62). In the auxiliary heat exchanger (62), for example, the air of about 10°C and the water of about 15°C exchange heat, thereby heating the air of about 10°C to about 12°C.

The air heated in the auxiliary heat exchanger (62) flows through the second air heat exchanger (64). In the second air heat exchanger (64), for example, the air of about 12°C and the water of about 20°C exchange heat, thereby heating the air to about 15°C, and cooling the water to about 17°C.

The air heated in the second air heat exchanger (64) is further heated by the electric heater (55). When the temperature of the air heated in the second air heat exchanger (64) exceeds a target room temperature, the electric heater (55) may be turned off.

The air dehumidified in this way is supplied to the room (5) as supply air (SA) through the supply duct (54).

### [Dehumidification-dominant Operation]

Dehumidification-dominant operation is dehumidifying operation which places importance on dehumidifying capacity than energy conservation. The dehumidification-dominant operation is carried out, for example, when temperature and humidity in the room are relatively high, i.e., in summer etc. A dehumidification load in the room may be detected to automatically perform the dehumidification-dominant operation when the dehumidification load is relatively high.

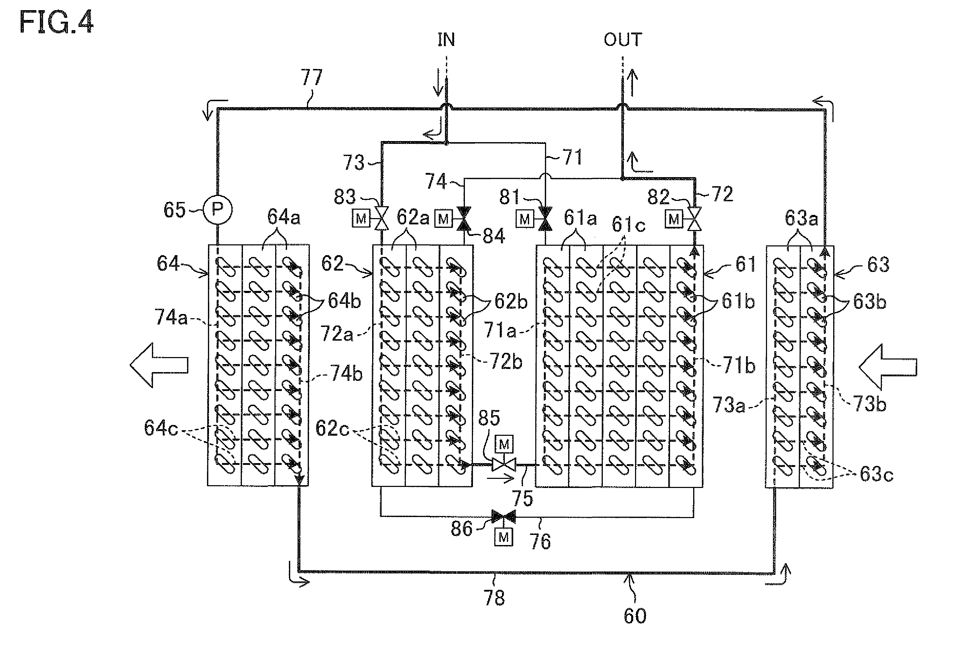

In the dehumidification-dominant operation, the compressor (22), the water pump (32), the chiller pump (42), and the blower (57) of the chiller unit (20) are driven. Basically, the electric heater (55) is turned on, and the sprinkling of the sprinkler (56) is stopped during the dehumidification-dominant operation. The controller (100) opens the second valve (82), the third valve (83), and the fifth valve (85), and closes the first valve (81), the fourth valve (84), and the sixth valve (86) (see FIG. 4).

In the dehumidification-dominant operation, the refrigerant circuit (21) performs the refrigeration cycle in the same manner as in the heat recovery operation. Water cooled in the second heat transfer pipe (25b) of the evaporator (25) passes through the chiller pump (42), and is transferred to the casing (51) of the air conditioning unit (50).

In the dehumidification-dominant operation, water passing through the inlet of the heating medium circuit (41) flows through the second inlet pipe (73) to enter the auxiliary heat exchanger (62). The water is diverted into the plurality of paths (62c, 62c, ...), and flows through the paths (62c, 62c, ...) to the upstream of the air flow. The water that passed through the paths (62c, 62c, ...) of the auxiliary heat exchanger (62) flows into the cooling heat exchanger (61) through the first coupling pipe (75). The water is diverted into the plurality of paths (61c, 61c, ...), and flows through the paths (61c, 61 c, ...) to the upstream of the air flow. The water that passed through the paths (61c, 61c, ...) of the cooling heat exchanger (61) is returned to the evaporator (25) of the heating medium circuit (41) through the first outlet pipe (72), and is cooled in the evaporator (25).

In the dehumidification-dominant operation described above, a second action of sending the water which is cooled in the evaporator (25) of the heating medium circuit (41), and sequentially flowed through the auxiliary heat exchanger (62) and the cooling heat exchanger (61) to the evaporator (25) is performed.

In the air conditioning unit (50), the outside air (OA) taken into the inlet duct (53) from the outside of the room flows through the air passage (52) in the casing (51). The air passes through the cooling heat exchanger (61), and then passes through the auxiliary heat exchanger (62). The water in the heating medium circuit (41) flows through the paths (62c, 62c, ...) of the auxiliary heat exchanger (62), and then flows through the paths (61c, 61c, ...) of the cooling heat exchanger (61) as described above. Thus, in the air passage (52), the air and the heating medium (water) flow substantially in the opposite directions in the two air heat exchangers (61, 62) to exchange heat therebetween. Specifically, the two air heat exchangers (61, 62) substantially function as a single convection heat exchanger in the dehumidification-dominant operation.

Thus, when the air cooled in the first air heat exchanger (63) passes through the cooling heat exchanger (61) and the auxiliary heat exchanger (62), the air is cooled in both of the heat exchangers (61, 62). As a result, the air which passed through the auxiliary heat exchanger (62) is more cooled in the dehumidification-dominant operation than in the heat recovery operation described above. This improves the dehumidifying capacity.

The air cooled/dehumidified in the two heat exchangers (61, 62) is heated by the second air heat exchanger (64) and the electric heater (55). The air dehumidified as described above is supplied to the room (5) as the supply air (SA) through the supply duct (54).

### -Advantages of First Embodiment-

In the above embodiment, the air which is not cooled/dehumidified yet in the cooling heat exchanger (61) is cooled in advance in the first air heat exchanger (63). This can reduce the cooling capacity required in the cooling heat exchanger (61), and can reduce, for example, the amount of water flowing in the heating medium circuit (41), or the cooling capacity required in the evaporator (25) (i.e., power of the compressor). This can reduce energy consumption of the air conditioning system (10).

In the second air heat exchanger (64), heat collected from the air in the first air heat exchanger (63) is used to heat the air. Thus, the dehumidifying capacity can be improved, and cold collected from the air can be used to cool the air again in the first air heat exchanger (63). Further, input to the electric heater (55) can be reduced.

In the auxiliary heat exchanger (62) during the heat recovery operation, heat collected from the air in the cooling heat exchanger (61) is used to heat the air. This can further improve the dehumidifying capacity, and can reduce the temperature of water sent to the evaporator (25) of the heating medium circuit (41). Thus, the cooling capacity required in the evaporator (25) can further be reduced, and energy consumption can further be reduced. In addition, the input to the electric heater (55) can be reduced.

In the cooling heat exchanger (61) during the heat recovery operation, the air and the water slowing in the opposite directions exchange heat therebetween. Thus, the air flowing out of the cooling heat exchanger (61) can be cooled to a temperature close to the temperature of the water introduced in the cooling heat exchanger (61), thereby cooling/dehumidifying the air more effectively in the cooling heat exchanger (61). On the other hand, the water flowing out of the cooling heat exchanger (61) can be heated to a temperature close to the temperature of the air flowing into the cooling heat exchanger (61). Thus, the air can be heated more effectively in the auxiliary heat exchanger (62), thereby further reducing the heating capacity required in the electric heater (55).

In the auxiliary heat exchanger (62) during the heat recovery operation, the air and water flowing in the opposite directions exchange heat therebetween. This can significantly heat the air, and significantly cool the water. Therefore, the cooling capacity required in the evaporator (25) can further be reduced, and the heating capacity required in the electric heater (55) can further be reduced.

The first air heat exchanger (63) which functions as the so-called convection heat exchanger can effectively cool the air. Since the temperature of the water flowing out of the first air heat exchanger (63) is relatively high, the second air heat exchanger (64) can effectively heat the air. Further, the second air heat exchanger (64) which also functions as the so-called convection heat exchanger can effectively heat the air. Since the temperature of the water flowing out of the second air heat exchanger (64) is relatively low, the first air heat exchanger (63) can effectively cool the air.

In the above embodiment, the air sequentially flows through the cooling heat exchanger (61) and the auxiliary heat exchanger (62), and the water sequentially flows through the auxiliary heat exchanger (62) and the cooling heat exchanger (61) in the dehumidification-dominant operation. Thus, the air can be cooled in both of the cooling heat exchanger (61) and the auxiliary heat exchanger (62), and the operation can be performed with priority given to the dehumidification of the air. Even when the outside humidity or temperature is significantly high, latent heat of the air can reliably be handled to supply the air to the inside of the room.

In the above embodiment, the passages in the heating medium circuit (41) through which the water flows are changed in the dehumidification-dominant operation in such a manner that both of the cooling heat exchanger (61) and the auxiliary heat exchanger (62) function as the so-called convection heat exchangers. Thus, in the dehumidification-dominant operation, the two heat exchangers (61, 62) substantially function as a single convection air heat exchanger. Therefore, the air can be cooled and dehumidified more effectively.

### [Alternative of First Embodiment]

The first embodiment described above may be modified in the following manner. In the following description, the same components as those of the first embodiment will not be described in detail.

### <First Alternative>

An air conditioning system (10) of a first alternative shown in FIGS. 5-7 includes a branch passage (66) into which part of the water circulating in the circulation circuit (60) is diverted, and an auxiliary cooling unit (90) for cooling the water flowing trough the branch passage (66).

The auxiliary cooling unit (90) includes a refrigerant circuit (91) which is filled with a refrigerant, and performs a vapor compression refrigeration cycle. A compressor (92), a radiator (93), an expansion valve (94), and an evaporator (95) are sequentially connected to the refrigerant circuit (91) of the auxiliary cooling unit (90). The refrigerant circuit (91) is connected to the branch passage (66) through the evaporator (95). The evaporator (95) constitutes an auxiliary cooling section which cools the heating medium flowing through the branch passage (66) by the refrigerant.

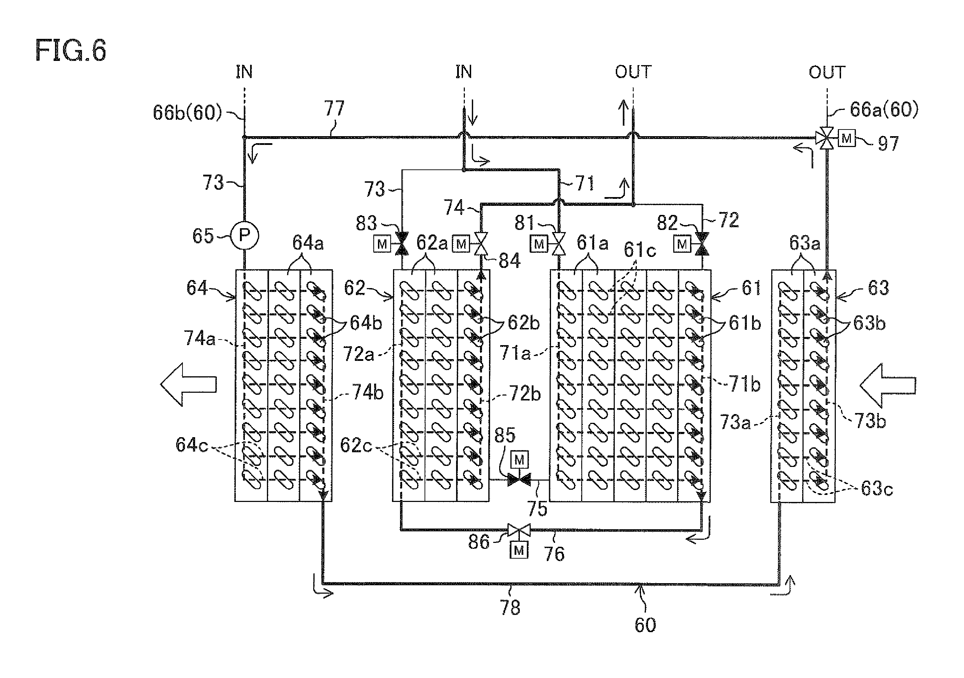

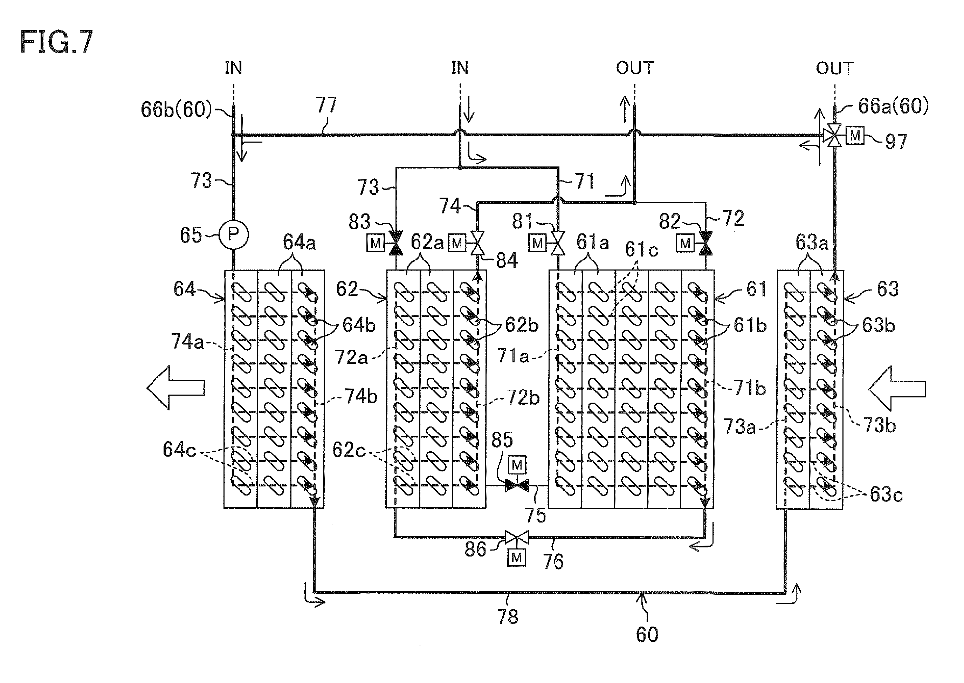

The branch passage (66) includes a first branch pipe (66a) closer to an inlet of the evaporator (95), and a second branch pipe (66b) closer to an outlet of the evaporator (95). An inlet end of the first branch pipe (66a) is connected to an upstream end of the third coupling valve (77). A three-way valve (97) is provided at a junction between the first branch pipe (66a) and the third coupling valve (77). The three-way valve (97) is configured to regulate the amounts of the heating medium sent to the third coupling valve (77) and the first branch pipe (66a) from the outlet (73b) of the first air heat exchanger (63). Specifically, the three-way valve (97) can be switched between a state where the entire heating medium flowing out of the outlet (73b) of the first air heat exchanger (63) is sent to the third coupling valve (77) (a state shown in FIG. 6), and a state where the heating medium flowing out of the outlet (73b) of the first air heat exchanger (63) is diverted to the third coupling valve (77) and the first branch pipe (66a) (a state shown in FIG. 7). The three-way valve (97) can be switched to a state where the entire heating medium flowing out of the outlet (73b) of the first air heat exchanger (63) is sent to the first branch pipe (66a). In this way, the three-way valve (97) constitutes a diverted flow control mechanism which regulates a flow rate of the heating medium flowing through the branch passage (66).

In the dehumidifying operation performed by the air conditioning system (10) of the first alternative, the controller (100) controls the degree of opening of the three-way valve (97) based on temperature and humidity of the target air, set room temperature (target temperature) and set room humidity (target humidity).

Specifically, for example, in the normal dehumidifying operation, the controller (100) controls the three-way valve (97) in the state shown in FIG. 6. Thus, the entire heating medium flowing out of the outlet (73b) of the first air heat exchanger (63) is not sent to the branch passage (66), but flows through the third coupling valve (77). Thus, in this case, the dehumidifying operation is performed in the same manner as described in the first embodiment.

For example, when the dehumidifying operation is performed when the humidity or temperature of the target air is excessively high, or the set room temperature or humidity is excessively low, the controller (100) controls the three-way valve (97) in the state shown in FIG. 7. Thus, part of the heating medium flowing out of the outlet (73b) of the first air heat exchanger (63) is sent to the branch passage (66). The heating medium flowing through the branch passage (66) is cooled in the evaporator (95) of the auxiliary cooling unit (90), and is then sent to the second air heat exchanger (64). Thus, in this operation, the air can be cooled/dehumidified also in the second air heat exchanger (64). Therefore, even when the latent heat load is high, the dehumidification can be performed to a preferred degree.

### <Second Alternative>

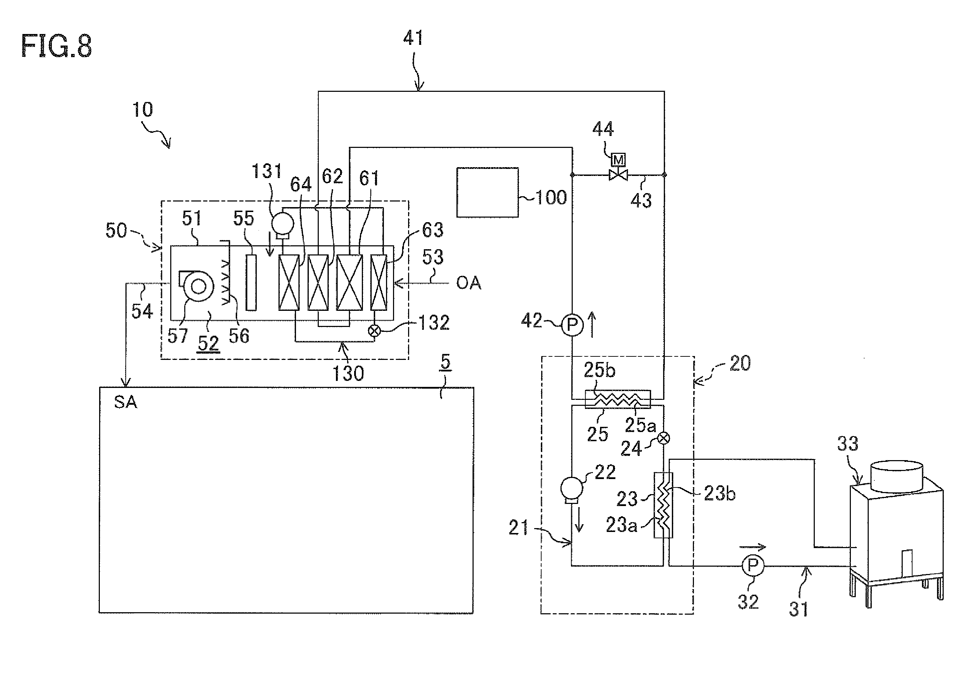

In an air conditioning system (10) of a second alternative shown in FIG. 8, a refrigerant circuit (130) is used as a circulation circuit in place of the circulation circuit (60) of the first embodiment. The refrigerant circuit (130) is configured to perform a vapor compression refrigeration cycle by circulating a refrigerant as a heating medium.

A compressor (131), a second air heat exchanger (64), an expansion valve (132), and a first air heat exchanger (63) are sequentially connected to the refrigerant circuit (130). In the second alternative, the second air heat exchanger (64) functions as a radiator (a condenser), and the first air heat exchanger (63) functions as an evaporator.

Specifically, when the air flowing through the air passage (52) passes through the first air heat exchanger (63), the refrigerant absorbs heat from the air to evaporate, thereby precooling the air. When the air cooled/dehumidified in the cooling heat exchanger (61) passes through the second air heat exchanger (64), the refrigerant dissipates heat to the air to heat the air. In the second alternative, the heat collected from the air to the refrigerant in the first air heat exchanger (63) is used to heat the air in the second air heat exchanger (64). This can reduce energy consumption of the air conditioning system (10).

### <Third Alternative>

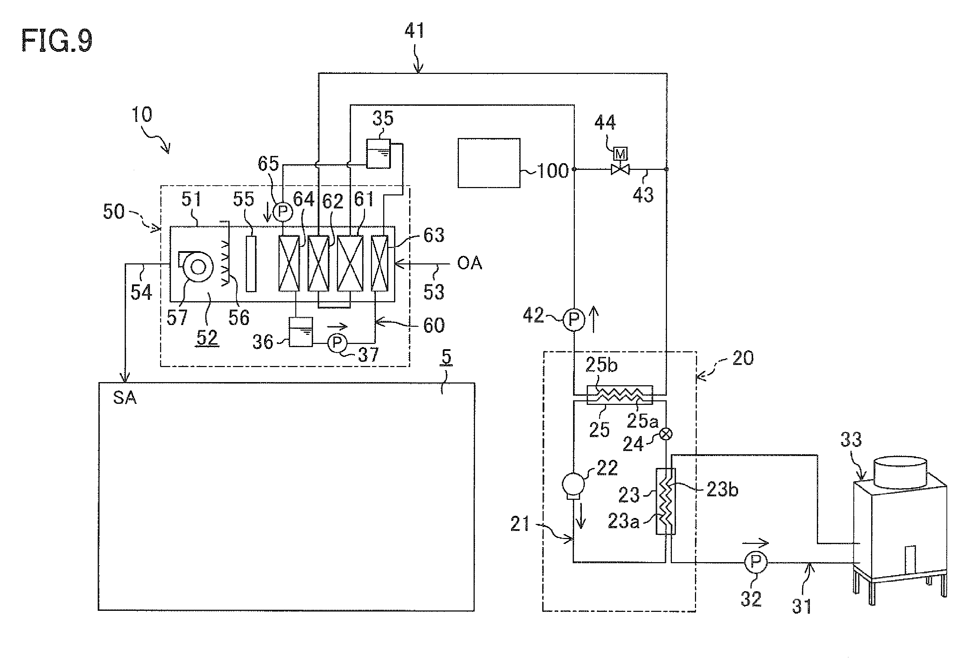

A circulation circuit (41) of a third alternative shown in FIG. 9 includes a first water tank (35), a second water tank (36), and an auxiliary pump (37).

The first water tank (35) and the second water tank (36) constitute a heating medium container for temporarily containing water as a heating medium. The first water tank (35) is provided in the third coupling valve (77) near an inlet end of the circulating pump (65). The auxiliary pump (37) is provided in the fourth coupling valve (78). The second water tank (36) is provided in the fourth coupling valve (78) near an inlet end of the auxiliary pump (37). The circulating pump (65) and the auxiliary pump (37) are centrifugal pumps, for example, and an amount of the heating medium transferred by each pump is variable by changing the number or revolutions of a motor.

The first water tank (35), the second water tank (36), the auxiliary pump (37), and the circulating pump (65) constitute a flow rate control mechanism which separately regulates the flow rate of the water flowing through the first air heat exchanger (63), and the flow rate of the water flowing through the second air heat exchanger (64).

The controller (100) of the third alternative includes a pump control section. The pump control section is configured to control the numbers of revolutions of motors of the circulating pump (65) and the auxiliary pump (37) (i.e., the flow rate of the heating medium).

Specifically, the pump control section regulates the flow rates of the heating medium transferred by the circulating pump (65) and the auxiliary pump (37) differently between daytime and nighttime.

In the daytime, the flow rate of water transferred by the auxiliary pump (37) is controlled to be higher than the flow rate of water transferred by the circulating pump (65) (first pump control operation). Specifically, in the first pump control operation, the flow rate of water flowing through the first air heat exchanger (63) is higher than the flow rate of water flowing through the second air heat exchanger (64). In the daytime, the temperature of the outside air (OA) is higher than that in the nighttime. With the flow rate of the water flowing through the first air heat exchanger (63) controlled to be relatively high, the outside air can sufficiently be cooled and dehumidified. When the flow rate of the water flowing through the second air heat exchanger (64) is lower than the flow rate of the water flowing through the first air heat exchanger (63), the amount of water which is heated in the first air heat exchanger (63), and is contained in the first water tank (35) increases.

In the nighttime, the flow rate of the water transferred by the circulating pump (65) is controlled to be higher than the flow rate of the water transferred by the auxiliary pump (37) (second pump control operation). Specifically, in the second pump control operation, the flow rate of the water flowing through the second air heat exchanger (64) is higher than the flow rate of the water flowing through the first air heat exchanger (63). In the nighttime, the temperature of the outside air (OA) is lower than that in the daytime. With the flow rate of the water flowing through the second air heat exchanger (64) controlled to be relatively low, excessive cooling of the outside air can be avoided. In the nighttime, a large amount of water of relatively high temperature accumulated in the first water tank (35) in the daytime flows through the second air heat exchanger (64). Thus, heat exchange between the water and the air is accelerated in the second air heat exchanger (64), i.e., heating of the air and cooling of the water are accelerated.

When the flow rate of the water flowing through the first air heat exchanger (63) is lower than the flow rate of the water flowing through the second air heat exchanger (64), the amount of water which is cooled in the second air heat exchanger (64), and is contained in the second water tank (36) increases.

Then, when the first pump control operation is performed again in the daytime, the flow rate of the water transferred by the auxiliary pump (37) is higher than the flow rate of the water transferred by the circulating pump (65) as described above. Thus, a large amount of water of relatively low temperature accumulated in the second water tank (36) in the nighttime flows through the first air heat exchanger (63). Therefore, heat exchange between the water and the air is accelerated in the first air heat exchanger (63), i.e., cooling of the air and heating of the water are accelerated.

In the third alternative described above, the flow rates of water transferred by the circulating pump (65) and the auxiliary pump (37) are changed between the daytime and nighttime, and the water is accumulated in the water tanks (35, 36). Thus, the cold collected in the nighttime can be used to cool the air in the daytime, and the heat collected in the daytime can be used to heat the air in the nighttime. This can further reduce energy consumption of the air conditioning system (10) in the heat recovery operation.

In the third alternative, the daytime operation and the nighttime operation may be switched, for example, using a timer etc., or based on the outside temperature (for example, the first pump control operation is performed when the outside temperature detected by a sensor is higher than a predetermined value, and the second pump control operation is performed when the outside temperature detected by the sensor is lower than the predetermined value), etc.

### <Fourth Alternative>

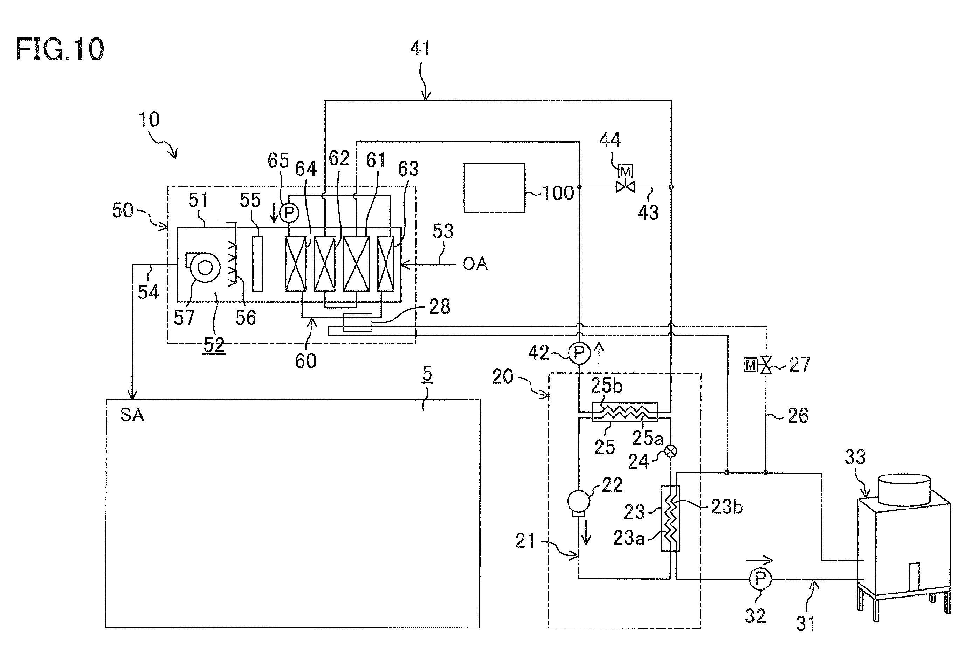

An air conditioning system (10) of a fourth alternative shown in FIG. 10 includes an internal heat exchanger (28) in which water in the radiation circuit (31) and water in the circulation circuit (60) exchange heat therebetween. Specifically, a diverting pipe (26) for diverting part of the water in the radiation circuit (31) is connected to the radiation circuit (31). A flow rate control valve (27) capable of regulating its degree of opening is provided in the diverting pipe (26). The internal heat exchanger (28) is configured to allow heat exchange between water circulating in the circulation circuit (60) and water diverted to the diverting pipe (26) to cool the water in the diverting pipe (26) by the water in the circulation circuit (60).

Specifically, in the above-described dehumidifying operation, when the flow rate control valve (27) opens the diverting pipe (26) at a predetermined degree of opening, the water in the radiation circuit (31) is diverted to the diverting pipe (26). The diverted water exchanges heat with the water of relatively low temperature flowing through the circulation circuit (60), and is cooled in the internal heat exchanger (28). Thus, in the fourth alternative, for example, when the outside temperature is low, cold of the water in the circulation circuit (60) can be used to cool the water in the radiation circuit (31).

### <Fifth Alternative>

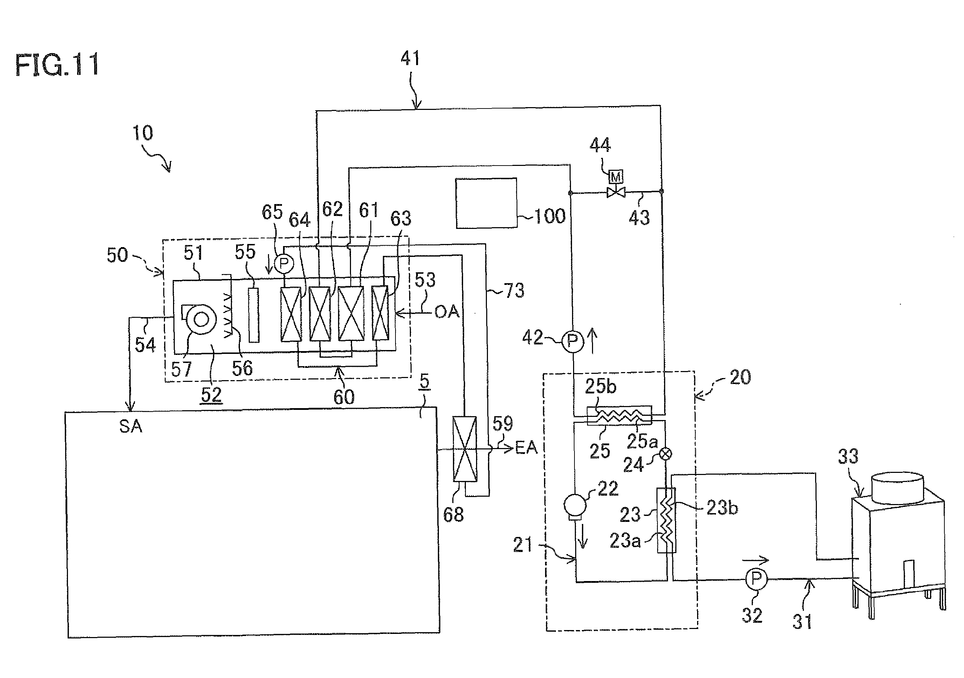

An air conditioning system (10) of a fifth alternative shown in FIG. 11 includes an exhaust duct (59), and a duct heat exchanger (68). An end of the exhaust duct (59) is connected to the room (5), and the other end is opened to the outside air. Thus, the exhaust duct (59) forms an exhaust passage through which the air in the room (5), which is target air of the air conditioning system (10), is discharged outside as exhaust air (EA). The duct heat exchanger (68) is arranged inside of the exhaust duct (59) to occupy the whole cross sectional area of the exhaust duct (59). The duct heat exchanger (68) is connected to a pipe between the first air heat exchanger (63) and the second air heat exchanger (64) (the third coupling valve (77)). Specifically, the duct heat exchanger (68) constitutes a sensible heat exchanger in which the water sent from the first air heat exchanger (63) to the second air heat exchanger (64) and the air sent from the room (5) to the outside exchange heat.

According to the fifth alternative, for example, in summer, cold of the room air can be added to the water in the circulation circuit (60). Thus, in the air conditioning unit (50), the cold collected to the circulation circuit (60) can be used to cool the air in the first air heat exchanger (63). For example, in winter, heat of the room air can be added to the water in the circulation circuit (60). Thus, in the air conditioning unit (50), the heat collected to the circulation circuit (60) can be used to heat the air in the second air heat exchanger (64).

### <Sixth Alternative>

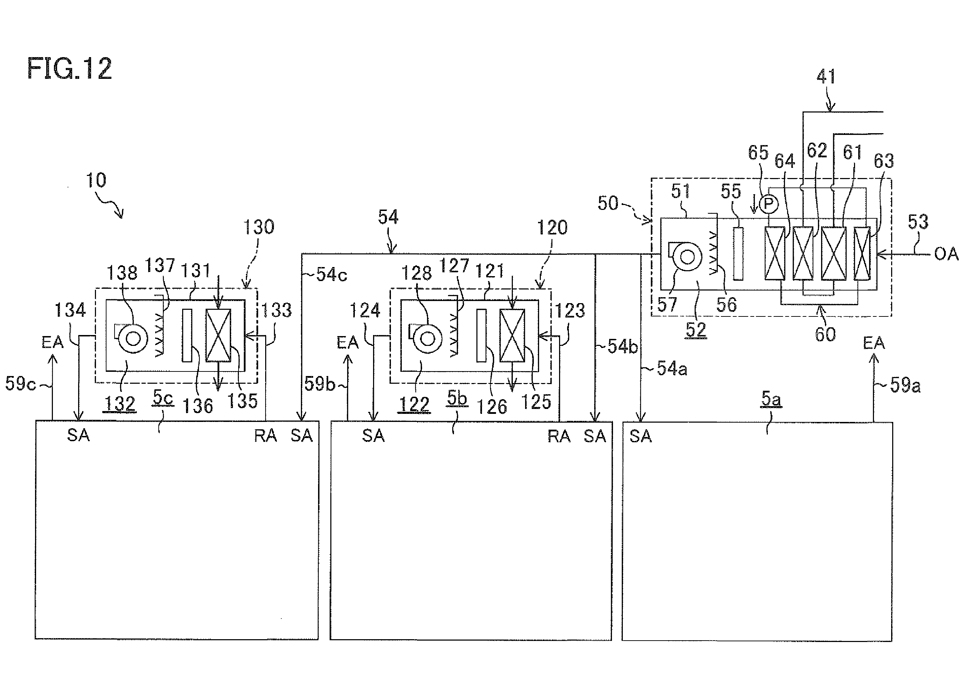

An air conditioning unit (50) of an air conditioning system (10) of a sixth alternative shown in FIG. 12 is configured to send supply air (SA) to three rooms (a first room (5a), a second room (5b), and a third room (5c)). Specifically, an outlet end of the supply duct (54) of the air conditioning unit (50) is branched into three air supply parts (a first air supply part (54a), a second air supply part (54b), and a third air supply part (54c)). An outlet end of the first air supply part (54a) is opened in the first room (5a), an outlet end of the second air supply part (54b) is opened in the second room (5b), and an outlet end of the third air supply part (54c) is opened in the third room (5c). An exhaust duct (59a) is connected to the first room (5a).

The air conditioning system (10) of the sixth alternative includes first and second auxiliary air conditioning units (120, 130). The first auxiliary air conditioning unit (120) is concerned with the second room (5b), and the second auxiliary air conditioning unit (130) is concerned with the third room (5c).

Each of the auxiliary air conditioning units (120, 130) includes a casing (121, 131) which forms an air passage (122, 132), an inlet duct (123, 133) which connects an inlet end of the air passage (122, 132) and a room (5b, 5c), and a supply duct (124, 134) which connects an outlet end of the air passage (122, 132) and the room (5b, 5c).

In the air passage (122, 132) of each of the auxiliary air conditioning units (122, 132), an air heat exchanger (125, 135), an electric heater (126, 136), a sprinkler (127, 137), and a blower (128, 138) are sequentially arranged in a direction from upstream to downstream of the air passage. Heat transfer pipes of the air heat exchangers (125,135) are filled with a heating medium such as water etc.

In the air conditioning system (10), the air conditioning unit (50) is operated in association with each of the auxiliary air conditioning units (122, 132). The air cooled/dehumidified in the air conditioning unit (50) is divided into the three air supply parts (54a, 54b, 54c) from the supply duct (54), and is supplied to the rooms (54a, 54b, 54c).

In each of the auxiliary air conditioning units (120, 130), the room air (RA) in each of the room (5b, 5c) is introduced into the air passage (122, 132) through the inlet duct (123, 133). The air is cooled/dehumidified by the heating medium flowing through the air heat exchanger (125, 135), and is then heated by the electric heater (126, 136). The air dehumidified in this manner is supplied to the rooms (5b, 5c) as supply air (SA).

### <Seventh Alternative>

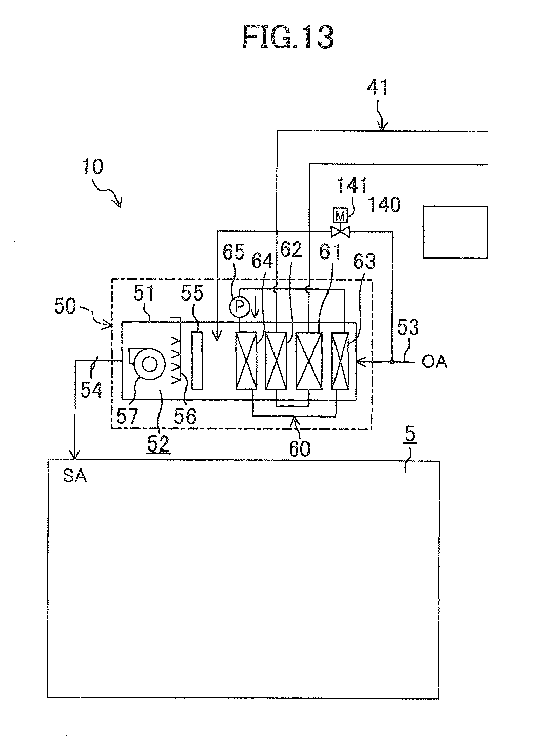

An air conditioning system (10) of a seventh alternative shown in FIG. 13 includes a branch duct (140), and an air flow control valve (141). An inlet end of the branch duct (140) is connected to the inlet duct (53). An outlet end of the branch duct (140) is opened between the second air heat exchanger (64) and the electric heater (55) in the air passage (52). Specifically, the branch duct (140) constitutes a bypass passage which transfers the air in the air passage (52) upstream of the first air heat exchanger (63) to the downstream of the second air heat exchanger (64). The air flow control valve (141) constitutes a bypass flow control mechanism which regulates the flow rate of the air flowing through the branch duct (140). The bypass flow control mechanism may be other mechanisms, such as a damper etc.

In the seventh alternative, the controller (100) controls the air flow control valve (141) based on operating conditions, thereby allowing operation suitable for a target latent or sensible heat load.

Specifically, for example, when the target latent heat load is high, the degree of opening of the air flow control valve (141) is reduced to reduce the flow rate of the air flowing through the branch duct (140). Thus, the flow rate of the air passing through the first air heat exchanger (63) and the cooling heat exchanger (61) is relatively high, and the air can be cooled/dehumidified to sufficiently handle the latent heat load.

For example, when the target latent heat load is not very high, but the target sensible heat load is relatively high, the degree of opening of the air flow control valve (141) is increased to increase the flow rate of the air flowing through the branch duct (140). Thus, the flow rate of the air passing through the first air heat exchanger (63) and the cooling heat exchanger (61) is relatively low. This reduces a cooling load of the evaporator (25) of the heating medium circuit (41), thereby reducing cooling capacity required in the evaporator (25).

In the seventh alternative described above, the operation can be performed based on the latent or sensible heat load. Thus, the latent and sensible heat loads can reliably be handled while keeping the energy consumption low. The latent heat load to be handled by the air conditioning system (10) can be calculated, for example, from a difference between a target room humidity set in the controller (100), and humidity of the outside air detected by a sensor etc. The sensible heat load to be handled by the air conditioning system (10) can be calculated, for example, from a difference between a target room temperature set in the controller (100), and temperature of the outside air detected by a sensor etc.

In the seventh alternative, the air flow control valve (141) is fully opened in winter etc., i.e., in heating operation for heating the outside air by the electric heater (55), or heating/humidifying operation for heating the outside air by the electric heater (55), and humidifying the heated air by the sprinkler (56). Specifically, the first air heat exchanger (63), the cooling heat exchanger (61), the auxiliary heat exchanger (62), and the second air heat exchanger (64) are stopped in the heating operation or the heating/humidifying operation. At this time, the flow rate of the air passing through the branch duct (140) is the highest. Thus, the flow rate of the air passing through each of the heat exchangers (61-64) can be reduced as much as possible, and pressure loss in each of the heat exchangers (61-64) can be reduced as much as possible. This can reduce power required by the blower (57) in the heating operation and the heating/humidifying operation.

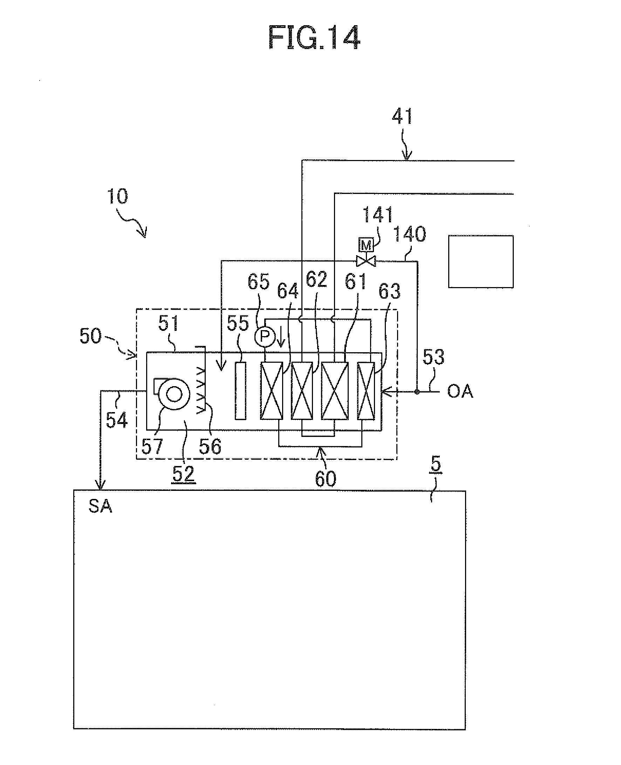

The outlet end of the branch duct (140) of the seventh alternative may be opened in the other part. Specifically, for example, the outlet end of the branch duct (140) may be opened downstream of the electric heater (55) as shown in FIG. 14.

### [Other Embodiments]

The above embodiment may be modified in the following manner.

The air conditioning system (10) according to the above embodiment (and the alternatives) takes the outside air (OA) into the air passage (52) to cool and dehumidify the air. However, the air conditioning system may take the room air (RA) into the air passage (52) to cool and dehumidify the room air.

In the above embodiment, the electric heater (55) is used as the heating section provided in the air passage (52) to heat the air. However, the heating section may be a condenser of a refrigerant circuit which performs a refrigeration cycle, or other heating members.

Two or more of the first to seventh alternatives may be combined to constitute the air conditioning system (10). The above-described embodiment has been set forth merely for the purposes of preferred examples in nature, and are not intended to limit the scope, applications, and use of the invention.

### INDUSTRIAL APPLICABILITY

As described above, the present invention is useful for dehumidification systems which cool and dehumidify air, and supply the dehumidified air to the inside of the room.

### DESCRIPTION OF REFERENCE CHARACTERS

- 10: Air conditioning system (dehumidification system)
- 25: Evaporator (cooling section)
- 35: First water tank (flow rate control mechanism)
- 36: Second water tank (flow rate control mechanism)
- 37: Auxiliary pump (flow rate control mechanism)
- 41: Heating medium circuit
- 51: Casing
- 52: Air passage
- 55: Electric heater (heating section)
- 59: Exhaust passage (exhaust duct)
- 61: Cooling heat exchanger
- 61c: Paths (intermediate passage)
- 62: Auxiliary heat exchanger
- 62c: Paths (intermediate passage)
- 63: First air heat exchanger
- 63c: Paths (intermediate passage)
- 64: Second air heat exchanger
- 64c: Paths (intermediate passage)
- 65: Circulating pump (flow rate control mechanism)
- 66: Branch passage
- 68: Duct heat exchanger (latent heat exchanger)
- 71a: Inlet
- 71b: Outlet
- 72a: Inlet
- 72b: Outlet
- 73a: Inlet
- 73b: Outlet
- 74a: Inlet
- 74b: Outlet
- 95: Evaporator (auxiliary cooling section)
- 97: Three-way valve (diverted flow control mechanism)
- 130: Circulation circuit (refrigerant circuit)
- 140: Branch duct (bypass pipe)
- 141: Air flow control valve (bypass flow control mechanism)

## Claims

1. A dehumidification system comprising:
a casing (51) which forms an air passage (52) through which air flows;
a heating medium circuit (41) which includes a cooling section (25) for cooling a predetermined heating medium, and in which the heating medium circulates;
a cooling heat exchanger (61) which is connected to the heating medium circuit (41), and is provided in the air passage (52) to cool and dehumidify the air by the heating medium flowing through the cooling heat exchanger (61) to supply the dehumidified air to the inside of a room;
an auxiliary heat exchanger (62) which is connected to the heating medium circuit (41) in series with the cooling heat exchanger (61), and is arranged downstream of the cooling heat exchanger (61) in the air passage (52);
a first air heat exchanger (63) which is connected to a circulation circuit (60, 130) in which the predetermined heating medium circulates, and is arranged upstream of the cooling heat exchanger (61) in the air passage (52); and
a second air heat exchanger (64) which is connected to the circulation circuit (60, 130) in series with the first air heat exchanger (63), and is arranged downstream of the auxiliary heat exchanger (62) in the air passage (52), wherein
the heating medium circuit (41) performs a first action of sending the heating medium which is cooled in the cooling section (25), and sequentially flowed through the cooling heat exchanger (61) and the auxiliary heat exchanger (62) to the cooling section (25).

2. The dehumidification system of claim 1, further comprising:
a heating section (55) which is arranged downstream of the second air heat exchanger (64) in the air passage (52) to heat the air.

3. The dehumidification system of claim 1, wherein
the cooling heat exchanger (61) includes an inlet (71a) which is positioned in a downstream part of the air passage (52), and through which the heating medium flows into the cooling heat exchanger (61), an outlet (71b) which is positioned in an upstream part of the air passage (52), and through which the heating medium flows out of the cooling heat exchanger (61), and an intermediate passage (61c) formed between the inlet (71a) and the outlet (71b).

4. The dehumidification system of claim 3, wherein
the auxiliary heat exchanger (62) includes an inlet (72a) which is positioned in the downstream part of the air passage (52), and through which the heating medium flows into the auxiliary heat exchanger (62), an outlet (72b) which is positioned in the upstream part of the air passage (52), and through which the heating medium flows out of the auxiliary heat exchanger (62), and an intermediate passage (62c) formed between the inlet (72a) and the outlet (72b).

5. The dehumidification system of claim 4, wherein
the first air heat exchanger (63) includes an inlet (73a) which is positioned in the downstream part of the air passage (52), and through which the heating medium flows into the first air heat exchanger (63), an outlet (73b) which is positioned in the upstream part of the air passage (52), and through which the heating medium flows out of the first air heat exchanger (63), and an intermediate passage (63c) formed between the inlet (73a) and the outlet (73b).

6. The dehumidification system of claim 5, wherein
the second air heat exchanger (64) includes an inlet (74a) which is positioned in the downstream part of the air passage (52), and through which the heating medium flows into the second air heat exchanger (64), an outlet (74b) which is positioned in the upstream part of the air passage (52), and through which the heating medium flows out of the second air heat exchanger (64), and an intermediate passage (64c) formed between the inlet (74a) and the outlet (74b).

7. The dehumidification system of any one of claims 1-6, wherein
the heating medium circuit (41) is configured to perform the first action, and a second action of sending the heating medium which is cooled in the cooling section (25), and sequentially flowed through the auxiliary heat exchanger (62) and the cooling heat exchanger (61) to the cooling section (25) in a switchable manner.

8. The dehumidification system of any one of claims 1-6, further comprising:
a branch passage (66) which diverts the heating medium circulating in the circulation circuit (60, 130), and introduces the diverted heating medium into the circulation circuit (60,130);
an auxiliary cooling section (95) which cools the heating medium flowing through the branch passage (66); and
a diverted flow control mechanism (97) which regulates a flow rate of the heating medium flowing through the branch passage (66).

9. The dehumidification system of any one of claims 1-6, further comprising:
a flow rate control mechanism (35-37, 65) which separately regulates a flow rate of the heating medium flowing through the first air heat exchanger (63), and a flow rate of the heating medium flowing through the second air heat exchanger (64).

10. The dehumidification system of any one of claims 1-6, further comprising:
an exhaust passage (59) through which the air in the room is discharged outside;
and
a sensible heat exchanger (68) in which the heating medium flowing through the circulation circuit (60, 130) and the air flowing through the exhaust passage (59) exchange heat.

11. The dehumidification system of any one of claims 1-6, further comprising:
a bypass passage (140) which transfers the air in the air passage (52) upstream of the first air heat exchanger (63) to the downstream of the cooling heat exchanger (61); and
a bypass flow control mechanism (141) which regulates a flow rate of the air flowing through the bypass passage (140).
